# EUROPEAN PATENT SPECIFICATION

(11) **EP 4 584 601 B1**
(45) Date of publication and mention of the grant of the patent: **08.04.2026**
(21) Application number: 23833882.6
(22) Date of filing: 19.12.2023
(51) Int. Cl.: G01R 31/12

(54) **METHOD AND SYSTEM FOR RECOGNISING PARTIAL DISCHARGES IN DC ELECTRICAL COMPONENTS**
VERFAHREN UND SYSTEM ZUR ERKENNUNG VON TEILENTLADUNGEN IN ELEKTRISCHEN GLEICHSTROMKOMPONENTEN
PROCÉDÉ ET SYSTÈME DE RECONNAISSANCE DE DÉCHARGES PARTIELLES DANS DES COMPOSANTS ÉLECTRIQUES CC

(30) Priority: 28.12.2022 IT 202200026985
(43) Date of publication of application: 16.07.2025
(73) Proprietor: Prysmian S.p.A., 20126 Milano (IT)
(72) Inventor: RIZZO, Giuseppe, 90146 Palermo (IT); ROMANO, Pietro, 90128 Palermo (IT); LI VIGNI, Vincenzo, 90146 Palermo (IT)
(74) Representative: Praxi Intellectual Property Milano
(86) International application number: PCT/IB2023/062923
(87) International publication number: WO 2024/141854

(56) References cited:
- SERI P ET AL: "Partial discharge measurements of DC insulation systems: the influence of the energization transient", 2019 IEEE CONFERENCE ON ELECTRICAL INSULATION AND DIELECTRIC PHENOMENA (CEIDP), IEEE, 20 October 2019 (2019-10-20), pages 377 - 380, XP033727579, DOI: 10.1109/CEIDP47102.2019.9009705
- NADERIALLAF HADI ET AL: "Measuring partial discharges in MV cables under DC voltage: procedures and results in steady state conditions", 2020 IEEE ELECTRICAL INSULATION CONFERENCE (EIC), IEEE, 22 June 2020 (2020-06-22), pages 18 - 21, XP033806058, DOI: 10.1109/EIC47619.2020.9158726
- FATTA ALESSIO DI ET AL: "Statistical analysis techniques for Partial Discharges measurement under DC voltage", 2022 IEEE 4TH INTERNATIONAL CONFERENCE ON DIELECTRICS (ICD), IEEE, 3 July 2022 (2022-07-03), pages 344 - 347, XP034176938, DOI: 10.1109/ICD53806.2022.9863226
- HAIQING NIU ET AL: "Noise rejection strategy and experimental research on partial discharge at DC voltage", PROPERTIES AND APPLICATIONS OF DIELECTRIC MATERIALS, 2009. ICPADM 2009. IEEE 9TH INTERNATIONAL CONFERENCE ON THE, IEEE, PISCATAWAY, NJ, USA, 19 July 2009 (2009-07-19), pages 489 - 492, XP031529264, ISBN: 978-1-4244-4367-3
- MONTANARI GIAN CARLO ET AL: "Measuring partial discharges in DC insulation systems. A challenge, but also a must", 2018 12TH INTERNATIONAL CONFERENCE ON THE PROPERTIES AND APPLICATIONS OF DIELECTRIC MATERIALS (ICPADM), IEEE, 20 May 2018 (2018-05-20), pages 128 - 131, XP033368874, DOI: 10.1109/ICPADM.2018.8401147
- MONTANARI GIAN CARLO ET AL: "Noise rejection and partial discharge identification in HVDC insulation systems", 2017 IEEE ELECTRICAL INSULATION CONFERENCE (EIC), IEEE, 11 June 2017 (2017-06-11), pages 425 - 428, XP033138808, ISBN: 978-1-5090-3965-4, [retrieved on 20170808], DOI: 10.1109/EIC.2017.8004616
- MONTANARI GIAN CARLO ET AL: "Noise rejection and partial discharge source identification in insulation system under DC voltage supply", IEEE TRANSACTIONS ON DIELECTRICS AND ELECTRICAL INSULATION, IEEE SERVICE CENTER, PISCATAWAY, NJ, US, vol. 26, no. 6, 1 December 2019 (2019-12-01), pages 1894 - 1902, XP011753878, ISSN: 1070-9878, [retrieved on 20191204], DOI: 10.1109/TDEI.2019.008210

## Description

### BACKGROUND

### Technical field

The present disclosure relates to techniques for recognising partial discharges in DC electrical components, such as an example, HVDC cables and MVDC cables.

### Description of the Related Art

The Partial Discharge (PD) phenomenon is one of the most common cause of fault of insulation for cables, accessories and electrical machines for the production and transmission of electrical energy. A PD is defined as an electrical breakdown that takes place only in part of the insulation. Each PD does not lead to the insulation failure but the repetition over time of a certain number of PD causes the degradation of the electric properties of the dielectric material until it breaks. The occurrence of PD into dielectric materials under voltage stress is typically related to the presence of defects originated during the manufacturing processes or created during the installation or the operation of the asset.

To date, methods based on the graphical analysis of the Phase Resolved PD (PRPD) pattern are widely used for the identification of PD under AC voltage stress. These methods cannot be used for the analysis of the PD activity under DC voltage due to the absence of a phase reference.

Statistical methods for the recognition of PD under DC voltage stress are described in the following documents:
R. Aldrian, G. C. Montanari, A. Cavallini and Suwarno, "Signal separation and identification of partial discharge in XLPE insulation under DC voltage," 2017 1st International Conference on Electrical Materials and Power Equipment (ICEMPE),
N. Morette, L. C. Castro Heredia, Thierry Ditchi, A.Rodrigo Mor, Y.Oussar, "Partial discharges and noise classification under HVDC using unsupervised and semi-supervised learning", in International Journal of Electrical Power & Energy Systems, Volume 121, 2020.

Such methods are based on the identification of clusters of points related to PD events in two-dimensional maps related to the characteristics of the detected signals. The TF map is one of the most used of this kind of graphic representation of PD events. In this case, the abscissa is the equivalent time length and the ordinate is the equivalent bandwidth of the detected signal.

With reference to the above cited methods concerning DC components, the Applicant observes that it cannot be excluded that also signals not coming from PD occurring in the insulation under measurement are grouped in clusters in a two dimensional map. Therefore, said techniques could lead to erroneously identify noise or PD coming from the outside as PD activity inside the insulation under test.

Document KR102378902 describes a HVDC cable partial discharge pattern analysis method having the following steps: obtaining measurement data related to partial discharge of the HVDC cable; analysing the partial discharge pattern based on the measurement data; diagnosing whether or not the HVDC cable is abnormal based on the partial discharge pattern.

Document CN-A-110427646 describes a DC cable partial discharge simulation method based on a simulation of the state of the DC cable to obtain a synthetic electric field inside a hole gas and judge whether the synthetic electric field is greater than the inception field strength of the partial discharge of the hole gas.

Document PCT/IT2022/050240 describes a method for calculating the electric field inside a dielectric material layer of a high voltage electric cable for direct electric current. Said method is designed to numerically calculate an electric field distribution referred to said dielectric material layer, substantially in real time and by solving differential equations expressed in discrete form.

The article "Partial discharge measurements of DC insulation systems: the influence of the energization transient", 2019 IEEE CONFERENCE ON ELECTRICAL INSULATION AND DIELECTRIC PHENOMENA (CEIDP), IEEE, 20 October 2019, pages 377-380, XP033727579, discloses PD event detection and discrimination involving measuring electromagnetic events from a DC cable following a voltage step or transient, plotting the repetition rate against time, and estimating a time constant for the approach to steady state of the cable electric field. PD events show an exponential fit following the initial voltage step, whereas noise events show no trend.

### BRIEF SUMMARY OF THE DISCLOSURE

The Applicant has noticed that the techniques of the prior art for recognising partial discharges in DC electrical components are not sufficiently reliable, notwithstanding their computational complexity, and are often not applicable to DC components in operation.

The Applicant has found that a method alternative to the known ones and showing satisfying performances can be based on the construction and subsequent analysis of a specific trend that put into relation estimated electric field data with partial discharge measurement data.

According to a first aspect, the present disclosure relates to a partial discharge recognition method comprising:
providing an electrical component comprising an insulation layer which can include a defect causing partial discharges;
putting in operation the electrical component by applying a DC electric voltage and generating a corresponding electrical current flowing in the electrical component;
estimating an electrical field magnitude distribution over time in said insulation layer by measuring physical parameters of the electrical component in operation;
detecting, in proximity to the electrical component, electromagnetic pulses and providing a trend of a detected pulse number;
processing the trend of detected pulse number and the electrical field magnitude distribution over time to obtain a correspondence trend representing a relation of said detected pulse number with electrical field magnitudes;
analysing the correspondence trend and selectively recognizing partial discharges and noise depending on an increasing of the detected pulse number as the electrical field magnitudes increase.

In an embodiment, analysing the correspondence trend comprises: recognizing partial discharges when the detected pulse number increases as the electrical field magnitudes increase in accordance with threshold-based criterion not recognizing partial discharges when the detected pulse number does not increase as the electrical field magnitudes increase, in accordance with said threshold-based criterion.

In an embodiment, said threshold-based criterion comprises: defining a partial discharge inception electric filed threshold dividing the correspondence trend; into a first sub-trend below the inception electric filed threshold and a second sub-trend above inception electric filed threshold; defining a comparison threshold; computing a ratio between the number of pulses associated with the second sub-trend and the number of pulses associated with the first sub-trend; compare said ratio with the comparison threshold and selectively recognizing partial discharges and noise depending on the result of the comparison.

In an embodiment, said electrical field magnitude distribution over time indicates trends over time of electrical field magnitude values assumed in a plurality of points of interest distributed in the insulation layer.

In an embodiment, the recognition method further includes: defining an observation time during which performing said measuring of physical parameters wherein said processing comprises: dividing said observation time into a plurality of sub-periods; calculating average electric field magnitude values, each associated to corresponding sub-periods; associating each calculated average electric field magnitude value to an electric field magnitude level among a plurality of electric field magnitude levels; calculating for any of said sub-periods a corresponding pulse number of said electromagnetic pulses detected in the corresponding sub-period, thus obtaining a plurality of pulse numbers; grouping the plurality of pulse numbers according to the plurality of electric field magnitude levels associated to the same sub-periods so as to obtain a plurality of groups of pulse numbers; computing an average number of pulses for each group of pulse numbers; each average number of pulses being associated to one of the plurality of electric field magnitude levels constructing said correspondence trend by expressing each average number of pulses in function of a corresponding electric field magnitude level.

In an embodiment, measuring the physical parameters is performed synchronously with the detection of the electromagnetic pulses.

In an embodiment, said recognition method, further comprises: computing a corrected electric field distribution over time by multiplying said electrical field magnitude distribution over time by an amplification/reduction coefficient to express an electric field that would be reached in the defect in said insulation layer.

In an embodiment, said recognition method further comprises: grouping the electromagnetic pulses into a first group of pulses and at least a second group of pulses according to a differentiation criterion based on at least one of the following pulse features: pulse shape; pulse magnitude, pulse repetition frequency, pulse rise time, pulse fall time, pulse duration, pulse peak.

In an embodiment, the recognition method further comprises: providing a first time trend of pulse number, associated with the first group of pulses, and at least a second time trend of pulse number associated with said at least a second group of pulses; wherein processing the trend of detected pulse number and the electrical field magnitude distribution over time to obtain the correspondence trend includes: processing said first time trend of pulse number and processing said at least a second time trend of pulse number.

In an embodiment, said differentiation criterion is based on the pulse shape.

In an embodiment, measuring physical parameters of the electrical component in operation comprises: measuring an electric voltage time trend in the electrical component; measuring an electric current time in the electrical component; measuring a temperature time trend along the electrical component.

In an embodiment, said electrical component is one of the following components: DC cable, HVDC cable, MVDC cable, DC cable joint, DC accessory. Wherein said electrical component is a DC cable having a dielectric layer.

According to a second aspect, the present disclosure relates to a partial discharge recognition system comprising:
- an electric field estimation apparatus configured to:
   measure physical parameters of an insulation layer of DC electrical component in operation; said insulation layer can include a defect causing partial discharges;
   estimating an electrical field magnitude distribution over time in said insulation layer from said measured physical parameters;
- a partial discharge sensor configured to detect, in proximity to the electrical component, electromagnetic pulses and providing a trend of a detected pulse number;
- a partial discharge recognition apparatus configured to:
   process the trend of detected pulse number and the electrical field magnitude distribution over time to obtain a correspondence trend representing a relation of said detected pulse number with electrical field magnitudes;
   analyse the correspondence trend and selectively recognizing partial discharges and noise depending on an increasing of the detected pulse number as the electrical field magnitudes increase.

### BRIEF DESCRIPTION OF THE DRAWINGS

Further characteristics and advantages will be more apparent from the following description of the various embodiments given as a way of an example with reference to the enclosed drawings in which:
Figure 1 schematically shows an example of a partial discharge recognition system;
Figure 2, shows as an example, a transversal section of a DC cable which can be tested by said partial discharge recognition system;
Figure 3 shows an example of distribution of evaluation points of interest in a dielectric layer of said DC cable,
Figure 4 is a flow chart representing an example of a method for recognizing partial discharges in DC electrical components, implementable by the system of figure 1;
Figure 5 is a flowchart representing a possible implementation of step of said method to construct a correspondence trend;
Figures 6A and 6B show two examples of correspondence trends;
Figure 7 refers to an experimental text and shows the time trend of a voltage applied between a conductor and a screen of a tested DC cable;
Figure 8 shows the time trend of the electrical current flowing in the DC cable of the experiment of figure 7;
Figure 9 shows the time trend of an estimated electric field in a point of interest of the tested DC cable;
Figure 10 shows a time trend of electromagnetic pulses as detected in proximity to said tested DC cable;
Figure 11 shows the electromagnetic pulse number distribution versus a main frequency obtained from said electromagnetic pulses;
Figure 12 shows a pulse number - electric field correspondence trend with reference to low frequency pulse phenomenon;
Figure 13 shows a pulse number - electric field correspondence trend with reference to high frequency pulse phenomenon.

### DETAILED DESCRIPTION

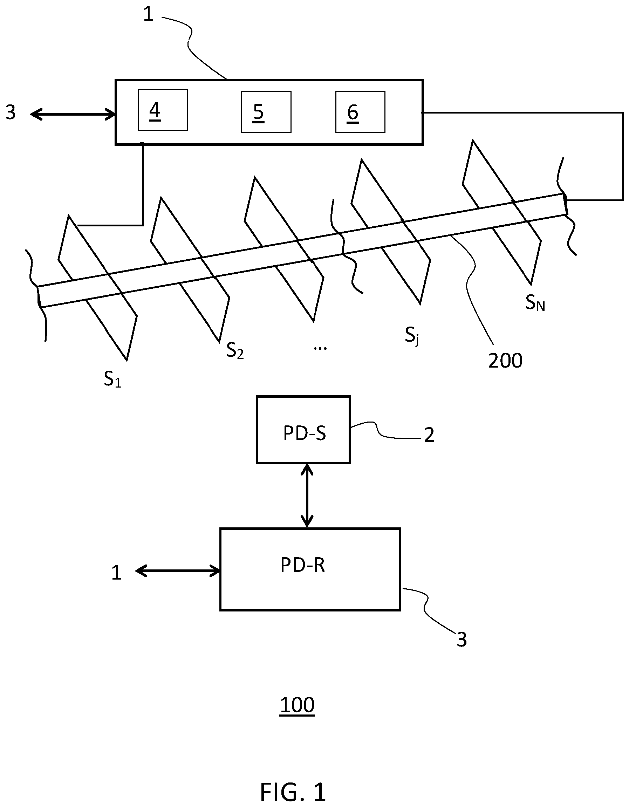

Figure 1 schematically shows an example of a partial discharge recognition system 100, configured to recognize partial discharges in DC electrical components (particularly, in an insulation layer of such component) such as cables (as DC cable 200 schematically represented in figure 1) or accessories (e.g. DC cable joints). The partial discharge recognition system 100 (hereinafter also called "recognition system") comprises an electric field estimation apparatus 1, at least a partial discharge sensor 2 (PD-S) and a partial discharge recognition device 3 (PD-R).

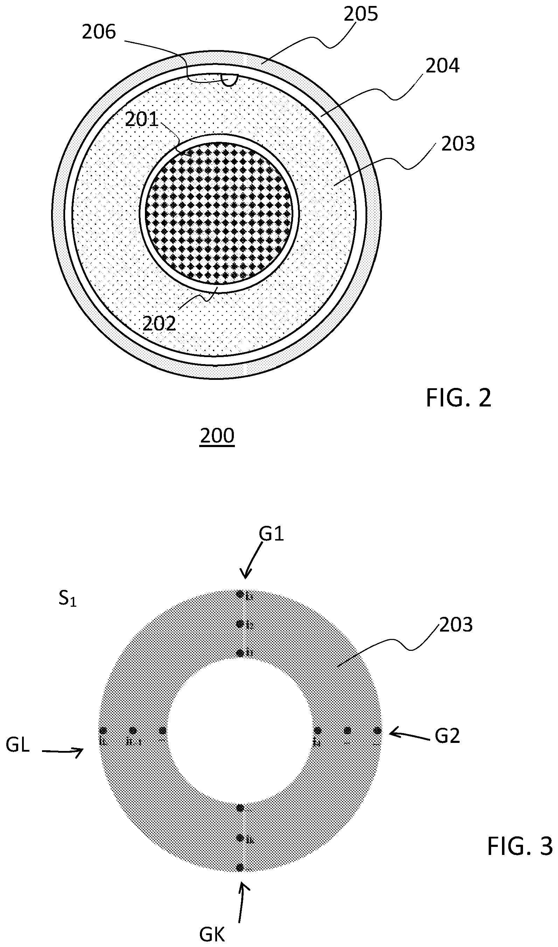

With reference to an example shown in figure 2, the DC cable 200 includes a conductor 201 (e.g. made by stranded aluminium or copper wires), surrounded by a first semiconductive layer 202 around which a dielectric layer 203 (i.e. an electrical insulation layer) is placed. The dielectric layer 203 is surrounded by a second semiconductive layer 204 which is covered by a screen 205 (e.g. made of metallic material). The DC cable 200 can be a Medium Voltage DC cable or a High Voltage DC cable. Particularly, Medium Voltage DC cables or accessories are configured to withstand operating voltage between about 1 kV and 30 kV, while High Voltage DC cable or accessories are configured to withstand operating voltage exceeding 30 kV. The DC electrical component, such as the exemplificative cable 200, can be an "on line" component: i.e. it is already installed in a power transmission system (e.g. an underground or submarine system). Alternatively, the DC electrical component is placed in a test room.

According to a particular embodiment, the field estimation apparatus 1 is configured to: perform measures of physical parameters (e.g. electrical current, voltage) of the DC cable 200 (when it is in operation), elaborate such parameters and provide an estimation of a distribution of the electric field E(t) in the dielectric layer 203 of the DC cable 200. Particularly, such estimated distribution comprises a plurality of magnitude values of the electric field at corresponding interest points over an observation time period.

With reference to an embodiment, the electric field estimation apparatus 1 is configured to operate in accordance with the method for calculating the electric field inside an insulation material of a DC cable described in document PCT/IT2022/050240, herein enclosed by reference. The field estimation apparatus 1 may comprise at least one temperature sensor 4 configured to measure a longitudinal temperature distribution over time, inside or outside the DC cable 200, in localized or in distributed manner. The temperature sensor 4 may include, as an example, a fibre optic-based sensor placed externally or internally to the DC cable 200. Moreover, the field estimation apparatus 1 comprises a voltage meter 5 configured to provide the voltage over time at one terminal of the DC cable 200, when in operation.

Furthermore, the electric field estimation apparatus 1 is provided with an ammeter 6 configured to measure the electrical current over time at the terminal of the DC cable 200. Alternatively, the voltage meter 5 and the ammeter 6 can be replaced by a SCADA (Supervisory Control and Data Acquisition) apparatus. Moreover, the electric field estimation apparatus 1 may also include suitable devices to convert possible detected analogic signals into digital data suitable for subsequent processing.

The electric field estimation apparatus 1 can comprise a computer or another processing device storing a software module adapted to perform processing of data relating to the temperature distribution, the voltage and the current over time and provide the distribution of the electric field in the dielectric layer 203 of the DC cable 200, over the observation time period. Said computer can be shared with the partial discharge recognition device 3.

The partial discharge sensor 2 can include one or more Partial Discharge (PD) detectors that allow detecting partial discharge pulses (or noise pulses) along the DC cable 200, providing corresponding analogic signals or digital data that can be acquired and recorded. Known PD detectors useful for online measurement of PD on cables and high voltage accessories comprise antenna sensors, High Frequency Current Transformers (HFCT) and others. Such detectors can be positioned at various points along the DC component path. Typically, such PD detectors are installed at the cable joints.

The partial discharge recognition device 3 is a processor device (e.g. a computer) adapted to process the data provided by the field estimation apparatus 1 and the partial discharge sensor 2 and recognize possible partial discharges occurred into the dielectric layer 203 of the DC cable 200, discriminating the discharge from noise (with the term "noise" is intended background noise or partial discharges not coming from the DC cable 200 or coming from points of the DC cable 200 which are not of intertest).

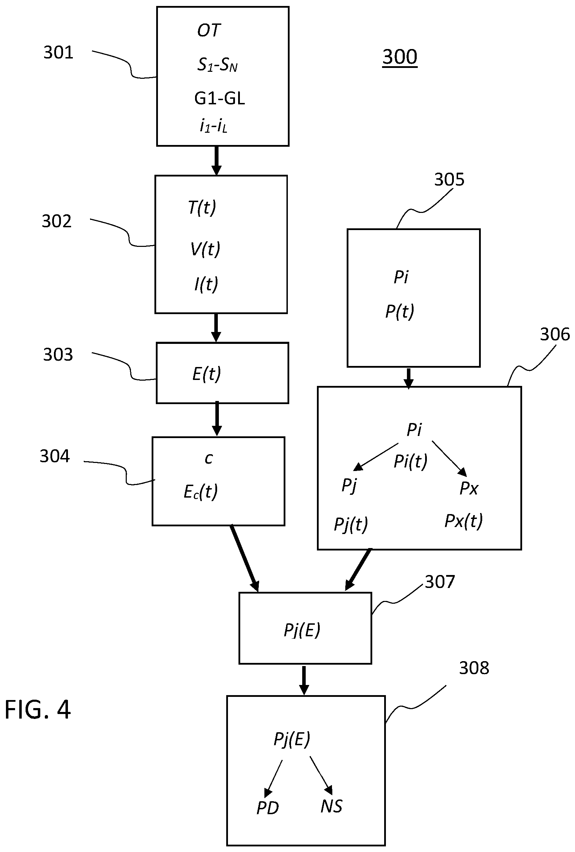

An example of a method 300 for recognizing partial discharges in DC electrical components, such as the DC cable 200, is described with reference to figure 4. The method 300 can be implemented by the above described recognition system 100. The dielectric layer 201 of the DC cable 200 may be free of defects or may include (as shown in figure 2, as an example) a cavity 206, corresponding to a defect in the dielectric layer 203, which can cause partial discharges.

In a first step 301, a plurality of points of interests *iₖ* within the dielectric layer 203 of the DC cable 200 are defined. In accordance with an example, a plurality of cross sections S₁-S_{N} are identified along the length of the DC cable 200 (Figure 1) to define corresponding evaluation zones. It is again observed that the electric field distribution in the dielectric layer 203 depends on the DC voltage V and the radial temperature distribution T. The DC voltage V between the conductor 201 and the screen 205 can be considered almost constant along the longitudinal axis of the DC cable 200 while the external temperature T can also vary according to the conditions of thermal exchange with the outside. For these reasons, it is preferably to section the cable 200 in such a way that the distance between two successive sections Sⱼ, Sⱼ₊₁ is of the same order of magnitude as the spatial resolution of the temperature sensor 4.

The cross sections S₁-S_{N} are defined by corresponding plane sections perpendicular to the longitudinal axis of the DC cable 200 and each of them includes a section of the dielectric layer 203.

As in the example shown in Fig. 3, each cross section Sⱼ includes a number of points of interest *iₖ* that are distributed radially and angularly. More particularly, as shown with reference to a first section S₁ in figure 3, each group of points may comprise groups of angularly differentiated points G1-G, localized at different angles around the conductor 201. Moreover, each group of angularly spaced points G1-GL may comprise a plurality of radially spaced points (e.g. i₁, i₂ and i₃) placed at different radial distances from the axis of the DC cable 200.

In the first step 301 is also defined an observation time OT, i.e. a time period in which the measures and, preferably, computations and estimations are performed.

In a second step 302, the measures necessary to calculate the electric field distribution are performed. In accordance with the described example, said measures are carried out employing the temperature sensor 4, the voltage meter 5 and the ammeter 6. Therefore, by the above-mentioned measures performed throughout the observation time OT, the following data are provided:
- Temperature distribution T(t) over time inside and/or outside the DC cable 200;
- Voltage V(t) over time between the conductor 201 and the screen 205 of the DC cable 200;
- Current I(t) over time in the conductor 201 of the DC cable 200.

In a third step 303, the above listed data provided by the electric field estimation apparatus 1 are sent to the computing device (e.g. included into the partial discharge recognition device 3) having a software suitable to perform the required estimation, preferably, in real time. This software calculates (i.e. estimates) the electric field magnitude over time E(t), for each point *iₖ* and for any section *Sj.* As already indicated, the electric field estimation apparatus 1 may be configured to operate according to the method described in document PCT/IT2022/050240 (the method has been also described in the Appendix of the present application). Employing the above-indicated method, the electric field E(t) over time is estimated in a condition in which the dielectric layer 203 is considered free of defects. It noticed that the electric field estimation apparatus 1 may apply electric field estimation methods of the type employable for on line DC components that are different from that described in document PCT/IT2022/050240.

In the above situation, the method 300 may include a fourth step 304 wherein a corrected electric field distribution over time E_{c}(t) that would be reached in a possible predetermined cavity centered in each point of interest is computed. The corrected electric field distribution Ec(t) is computed multiplying the electric field E(t) calculated by the above method by an amplification/reduction coefficient c. This coefficient can be calculated, as an example, taking into account the theories available in the following documents:
- G. Rizzo, V. L. Vigni, A. Imburgia, P. Romano, R. Candela and G. Ala, "Predictability of PD inception in defects included in HVDC cables by conductivity models calibrated through experiments," 2022 IEEE 4th International Conference on Dielectrics (ICD), 2022, pp. 106-109.
- K. R. Kumar and N. Haque, "Effect of Temperature and Void Location on Partial Discharge Inception Voltage in HVDC Cables," 2022 International Conference for Advancement in Technology (ICONAT), 2022, pp. 1-4.
- H. Naderiallaf, P. Seri and G. C. Montanari, "Designing a HVDC Insulation System to Endure Electrical and Thermal Stresses Under Operation. Part I: Partial Discharge Magnitude and Repetition Rate During Transients and in DC Steady State," in IEEE Access, vol. 9, pp. 35730-35739, 2021

As an example, the amplification/reduction coefficient c can be calculated by means of the ratio between the estimated equivalent electrical conductivity of the cavity 206 and the electrical conductivity of the dielectric material 203 around the cavity, as described in the last document of the above-indicated list.

In a fifth step 305, the partial discharge sensor 2 is employed to record electromagnetic pulses Pi detected in proximity to the DC cable 200 and obtain a corresponding time trend of pulses P(t) (which can be expressed into digital form). Particularly, it is observed that the acquisition of the pulses Pi by the partial discharge sensor 2 is performed synchronously with the measures performed for the calculation the electric field distribution E(t) over time. This synchronism allows associating electric field magnitude values obtained with measures carried out in a specific time instant or time interval with pulses detected in the same time instant or interval, as it will be clarified later.

The method 300 may include an optional sixth step 306 in which the recorded pulses Pi can be differentiated by means of a differentiation criterion, such as for example the shape of the captured pulse. In the sixth step 306 the recorded pulses Pi can be separated in two or more groups of pulses (e.g. groups Pⱼ and Pₓ), with corresponding time trends (Pⱼ(t) and Pₓ(t)). Others possible differentiation criteria can be based on the pulse magnitude, pulse repetition frequency, pulse rise time, pulse fall time, pulse duration, pulse peak, etc. This sixth step 306 can be preferably performed when it is believed that a high noise level is present.

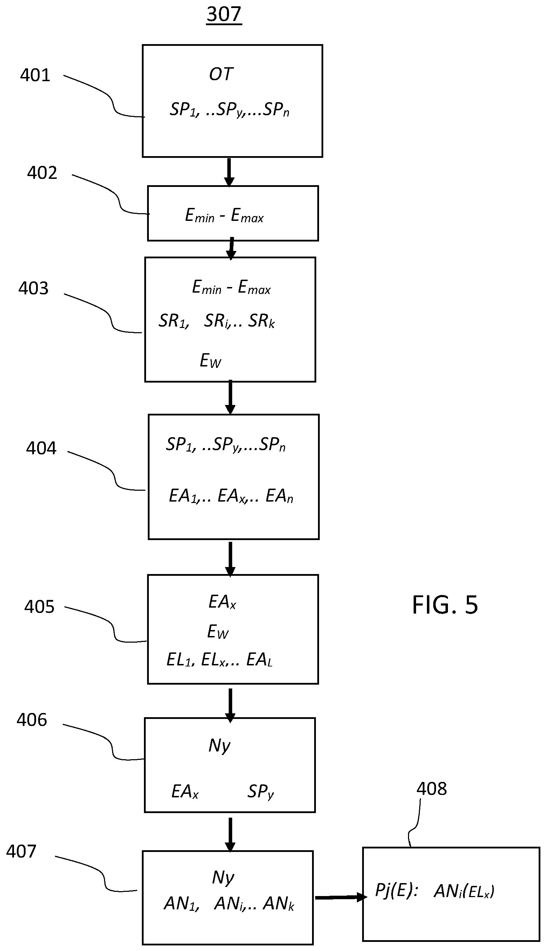

In a seventh step 307, a processing is performed to express the number of pulses of each of the groups of pulse time trends Pⱼ(t) and Pₓ(t) as function of the corrected electric field distribution Ec(t), for a cavity centred in each point of interest. This processing allows constructing a pulse-electric field correspondence trend (e.g. under the form of a pattern) Pj(E) representing the correspondence (i.e. the relation) between the electric field in a predetermined cavity centred in each of the points of interest and the number of pulses (Pᵢ) detected by the partial discharge sensor 2 at the same time interval. Said seventh step 307 can be performed by the partial discharge recognition device 3. It is noticed that the seventh step 307 can be applied to the pulse time trend P(t) when the differentiation of the optional sixth step 306 is not performed. Alternatively, the seventh step 307 can be performed considering the electric field distribution E(t) and not the corrected one Ec(t). A particular embodiment of the seventh step 307 will be described later with reference to figure 5.

The pulse-electric field correspondence trend Pj(E) is processed by the partial discharge recognition device 3, in order to decide if partial discharges have been recognized among the detected pulses Pi or such pulses are only due to noise. The above decision is performed considering that the partial discharge activity is expected to grow with the increase of the electric field magnitude reached inside a cavity in the dielectric layer 203. A significantly increasing of the correspondence pulse-electric field trend Pj(E) with the electric field indicates a real partial discharge activity at a given point of interest. Alternatively, if the pulse activity appears independent of the electric field level calculated at a given point, the acquired signals refer to noise or activity from outside or another point of interest of the DC cable 200.

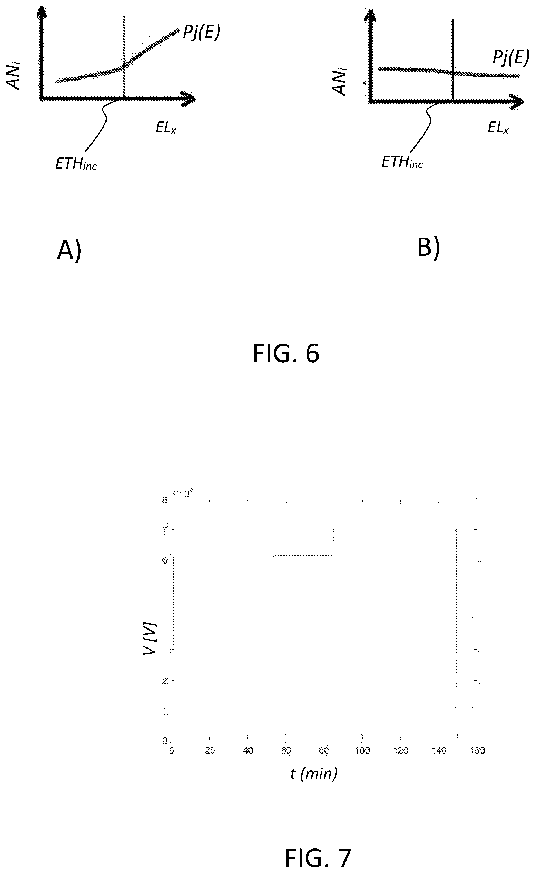

In view of the above considerations, the partial discharge recognition device 3 is configured to analyse (eight step 308) the pulse-electric field correspondence trend Pj(E) and recognize partial discharges (output PD) when the number of detected pulses increases with the increasing of the magnitude of the corrected electric field distribution Ec(t). On the contrary, the partial discharge recognition device 3 does not recognize partial discharged PD (output NS) when the number of detected pulses does not increase with the increasing of the magnitude of the corrected electric field distribution Ec(t). Advantageously, the analysis of the pulse-electric field correspondence trend Pj(E) to decide about the presence or the absence of partial discharges is based on one or more thresholds. A particular embodiment, of the eight step 308 will be described later with reference to figures 6 and 7.

### Particular embodiment of the seventh step 307

A particular embodiment of the seventh step 307 is now described with reference to figure 5. According to the described example, the group of pulse time trends Pⱼ(t) and the corrected electric field distribution Ec(t) are considered. This processing allows constructing a particular pulse-electric field correspondence trend which is particularly adapted to a histogram representation.

According to said embodiment, the seventh step 307 includes a first subdivision step 401, wherein the observation time OT is subdivided into a plurality of time intervals hereinafter called "sub-periods" SP₁, SP₂, ..., SP_{y}, SPₙ having, preferably, the same width. The width of the time intervals can be selected according to the application. For example, the time intervals can have a width between 1 to 60 seconds, for example 5 seconds.

Moreover, in a range definition step 402 the corrected electric field distribution Ec(t) is analysed to establish an electric field range between a minimum value Eₘᵢₙ and a maximum value Eₘₐₓ which includes all the values that the electric field can potentially reach at each interest point during operation, if there is a cavity 206 with predetermined characteristics around the given point.

In a second subdivision step 403, the range between *Emin* and *Emax* is subdivided by into a plurality of sub-ranges SR₁,.. SRᵢ, ...SRₖ of equal width E_{W}.

In a first average calculation step 404, for each sub-period SP_{y}, an average magnitude value E_{Ax} of the magnitudes of the corrected electric field Ec(t) assumed in the corresponding sub-period is computed.

Each average magnitude value E_{Ax} can be further associated to an additional information indicating an electric field magnitude level EL₁, ELₓ,.. EA_{L} within which the average magnitude value E_{Ax} is included (level association step 405). Different increasing magnitude levels can be defined basing on the number of widths E_{W}, where E_{W} has been defined in the second subdivision step 403. As an example, considering a width E_{W} = 2 V/m, an average value E_{A1} = 1,5 V/m is included into a first level EL₁ having the magnitude of a single width E_{W} ; while an average value E_{A2} = 2,5 V/m is included into a second level EL₂ having an magnitude between a single width E_{W} and the double of the width E_{W}. In this way, for each sub-period SP_{y}, the corresponding average magnitude value E_{Ax} and electric field magnitude level ELₓ are associated.

Moreover, in a pulse number calculation step 406 the number Ny of pulses Pⱼ acquired in any sub-period SP_{y} is computed. Therefore, each calculated number of pulses Ny is also associated, by means of the corresponding sub-period SP_{y}, to the electric field magnitude level EAₓ.

In a second average calculation step 407, the number Ny of pulses Pⱼ acquired in any sub-period SP_{y} are grouped according to the associated electric field magnitude level ELₓ. As an example, in said step 407 are found three subperiods (e.g. SP₅, SP₉, SP₁₂) associated with a first electric field magnitude level EL₁. In these three sub-periods SP₅, SP₉, SP₁₂ the corresponding number of pulses are: N₅, N₉, N₁₂. Then, an average number of pulses AN₁ per unit time is computed (AN₁: N₅ + N₉ + N₁₂ /3). The average number of pulses AN₁ per unit time is associated to the specific electric field magnitude level EL₁. Analogously, according to a further example, another average pulse number AN₂, obtained by performing the average of the pulse numbers N₂, N₁₄, assumed in periods SP₂, SP₁₄, is associated to another specific electric field magnitude level EL₂.

Therefore, in the second average calculation step 407 a plurality of average number of pulses AN₁, ...ANᵢ, ...ANₖ are computed.

In a pattern creation step 408, a particular correspondence pulse-electric field trend *Pⱼ(E)* is generated by associating each average number of pulses ANᵢ with the corresponding electric field magnitude level ELₓ: ANᵢ(ELₓ). The correspondence pulse-electric field trend ANᵢ (ELₓ) is evaluated for each point of interest iₖ. The correspondence pulse-electric field trend ANᵢ(ELₓ) is also called in the present description as Electric Field Resolved PD pattern (EFRPD).

### Particular embodiment of the eight step 308

As above described, in the eight step 308 the partial discharge recognition device 3 is configured to analyse the pulse-electric field correspondence trend Pj(E), to recognize or not recognize partial discharges. Figures 6A) and 6B) show two alternative exemplary Electric Field Resolved PD patterns (ANᵢ(ELₓ)).

Said eight step 308 comprises a step of defining a partial discharge inception electric filed threshold ETH_{inc}. The inception threshold ETH_{inc} allows dividing the pulse-electric field correspondence trend Pj(E) into two portions. Said inception threshold ETH_{inc} can be calculated by means of the known Paschen law.

Moreover, the eight step 308 comprises a step of computing of a ratio R_{P} between the total number of pulses recorded when the electric field was above and below the above discharge inception electric filed threshold ETHinc. If the ratio R_{P} is greater than a comparison threshold R_{TH} (as the situation of figure 6A) it is possible to decide that a real partial discharge activity occurred in the DC cable 200. If the ratio R_{P} is lower than the comparison threshold R_{TH} (as the situation of figure 6B) it is possible to decide that no partial discharge activity occurred in the DC cable 200 and the detected pulses are due to noise.

### Experiment

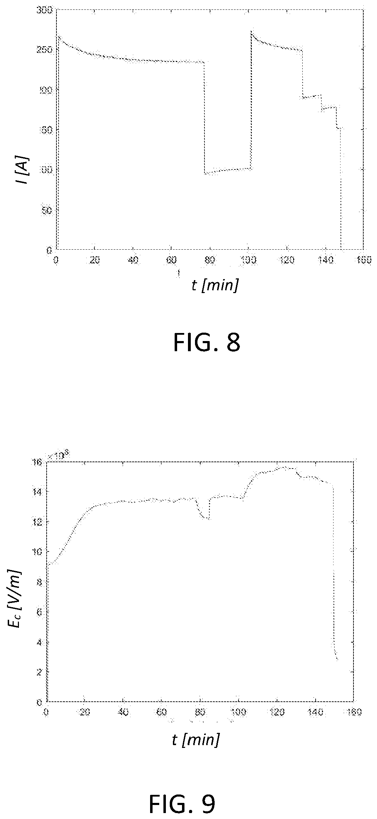

The Applicant has applied the above method 300 to a DC cable analogous to the above-described cable 200. At the outer boundary of the dielectric layer 203 an artificial defect 206 has been created as shown in figure 2. It has considered an observation period OT of 150 minutes during which the applied voltage V (between the conductor 201 and the screen 205) has assumed the time trend shown in figure 7 and current I has assumed the time trend shown in figure 8.

The voltage V has been applied by means of an HVDC voltage generator whilst a transformer-like device induced a current to flow through the conductor of the cable. During the observation transient, the voltage V has been measured through the output signal of the HVDC voltage generator, the current I has been measured by means of a Rogowski sensor and the temperature T at the outer surface of the cable 200 has been measured by a PT100 sensor.

During the observation period OT, the time trend of the electric field was calculated (according to above described third step 303 and fourth step 304) by the calculation method described in document PCT/IT2022/050240. The amplification/reduction coefficient c has been calculated according to the method described in the above indicated document of H. Naderiallaf, P. Seri and G. C. Montanari. Particularly, the equivalent electrical conductivity of the cavity 206 has been obtained by considering the parallel between the conductivity of the gas inside the cavity 206 and the surface conductivity of the cavity 206.

Figure 9 shows the time trend of the corrected electric field E_{c}(t) at the point of interest in accordance with the fourth step 304 of the method 300, i.e. the computed electric filed multiplied by the estimated amplification/reduction factor c.

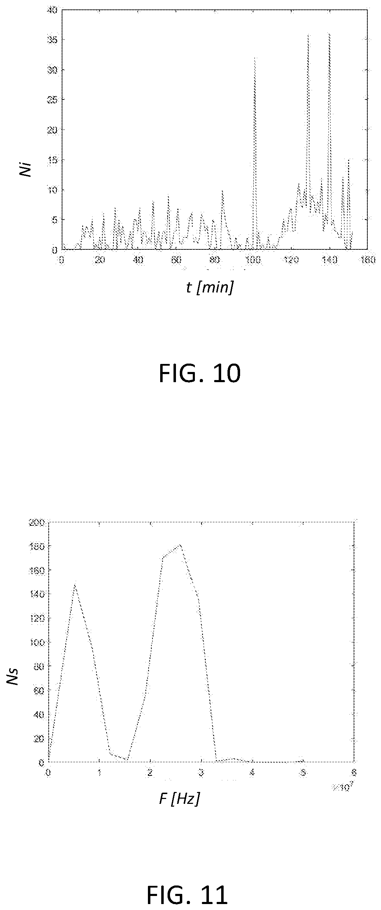

To implement the fifth step 305, an antenna sensor has been used (as partial discharge sensor 2) to detect and record electromagnetic pulses Pi. The recorded time trend of the number of pulses Pᵢ is shown in figure 10 (number Nᵢ of pulses versus time).

Moreover, in accordance with the sixth step 306, the recorded pulses Pᵢ have been differentiated by phenomenon. In greater details, a Fast Fourier Transform has been performed for each measured signal and, for each of them, the main frequency component *F* has been identified. A main frequency distribution has been obtained for the detected signals as shown in figure 11: number of signals Nₛ versus main frequency *F.* In addition, from the distribution of figure 11, the main peaks have identified and the detected signals have been divided into different discharge phenomena according to the belonging of their main frequency component to one of the aforementioned main peaks. Two main discharge phenomena have ben encountered: one at lower frequency and another at higher frequency.

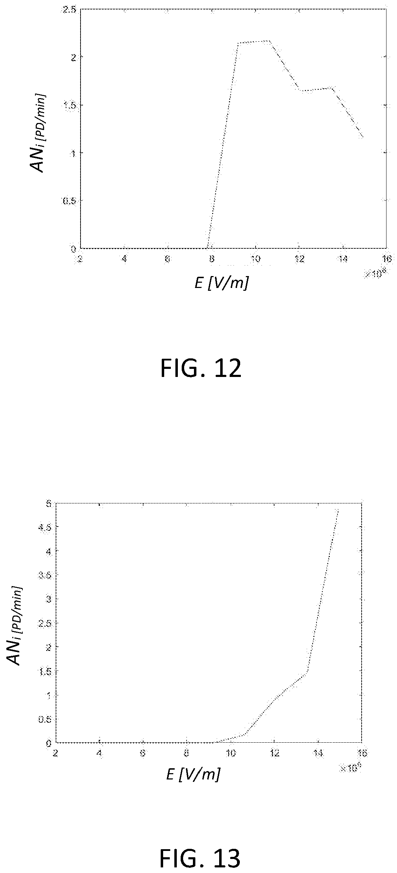

Moreover, the steps described with reference to figure 5 has been performed and the *EFRPD* pattern has constructed for both the detected phenomena. The EFRPD pattern for the low frequency PD phenomenon is shown in figure 12 while the EFRPD pattern for the high frequency PD phenomenon is shown in Fig. 13. With reference to the inception threshold ETHinc it has been set to 13 kV/mm whilst the comparison threshold R_{TH} has been set to 4. Both trends of figure 12 and figure 13 allow deciding that there was a presence of partial discharges.

The performed experiment has confirmed the efficiency of the method described.

### Appendix: the method of document PCT/IT2022/050240

The method described in document PCT/IT2022/050240 allows calculating the electric field inside a dielectric material layer of a high voltage electric cable for direct electric current. Said method is designed to numerically calculate an electric field distribution referred to said dielectric material layer, substantially in real time and by solving differential equations expressed in discrete form.

Particularly, the method disclosed is for calculating an electric field inside a dielectric material layer (such as the later 203) of a high voltage electric cable (such as DC cable 200) for direct electric current. The electric cable described in the above cited document is of the type comprising, from the inside towards the outside: a conductor having a longitudinal axis, a first semiconductive material layer, said dielectric material layer, a second semiconductive material layer, a metallic material layer called shield (or screen).

The method comprises a step A: identifying one or more areas Sⱼ, with j=1,2...N where N is a positive integer, each of which is arranged along said electric cable, on a respective plane Pj transverse to the longitudinal axis of said electric cable and has a geometric shape defined by a closed reference line.

Moreover, the method includes a step B: associating a respective computational domain DT_{J} with each area S_{J}, as well as associating a respective further computational domain DE_{J} with a further area which is a portion of said area Sⱼ and is arranged inside said electric cable, between said first semiconductive material layer and said second semiconductive material layer, wherein said further area is included between a first closed line and a second closed line , said computational domain DT_{J} being discretized through a set of finite elements e_{J1},e_{J2}...e_{JM}, said further computational domain DE_{J} being discretized through a further set of finite elements e_{JX},e_{JY}...e_{JL}, in transversal section said first closed line being a first contact line between the conductor and said first semiconductive material layer and said second closed line being a second contact line between said second semiconductive layer and said shield.

The method also comprises the following step C which defines the acquisition of:
- a value of temperature TE_{J} at each area Sⱼ through temperature measuring means;
- a value of voltage V between said conductor and said shield, wherein said value of voltage V is obtained through a voltage measuring device or is a predetermined value of voltage;
- a value of electric current *I* flowing along the longitudinal axis of the conductor, wherein said value of electric current *I* is obtained through an electric current measuring device or is a predetermined value of electric current.

Furthermore, said method comprises the following step D): calculating, by means of a numerical finite element method, a respective temperature distribution Te_{J1},Te_{J32}...Te_{JM} for each computational domain DT_{J}, wherein each value of temperature of a temperature distribution is associated with a respective finite element e_{J1},e_{J2}...e_{JM} of a respective computational domain DT_{J}, each temperature distribution being calculated by solving: Fourier's law for conducting heat in transient conditions, starting from said temperature values TE_{J}, from said measured electric current values *I*, and from a predetermined temperature distribution T₀.

In addition the method comprises a step E: calculating, by means of a further numerical finite element method, a respective electric field distribution Ee_{JX} ,Ee_{JY}...E_{JL} for each further computational domain D_{EJ}, wherein each value of electric field of an electric field distribution is associated with a respective finite element e _{JX}, e_{JY}...e_{JL} of said further computational domain DE_{J}, each electric field distribution being calculated by solving:
- Gauss's law for an electric field E in transient conditions, applied to each finite element e_{JY} falling into the dielectric material layer,
- the law of continuity of electric current in stationary conditions applied to each finite element e_{JL} which falls in the first semiconductive material layer or in the second semiconductive material layer and which does not contact one or more finite elements e_{JL} which fall into the dielectric material layer,
- Schottky's law referred to an injection of electric charges in correspondence of a contact line between different materials, applied to each finite element e_{JX} which falls into the first semiconductive material layer or in the second semiconductive material layer and contacts one or more finite elements e_{JY} which fall into the dielectric material layer,
- the relationship between electric field *E* and said voltage V, starting from boundary conditions applied to said first closed line and to said second closed line of the respective further computational domain D_{EJ}, in which said boundary conditions depend on said voltage value V and on a predetermined electric charge density distribution p₀.

## Claims

1. Partial discharge recognition method (300) comprising:
providing an electrical component (200) comprising an insulation layer (203) which can include a defect (206) causing partial discharges;
putting in operation the electrical component (200) by applying a DC electric voltage (V(t)) and generating a corresponding electrical current (I(t)) flowing in the electrical component (200);
estimating (303; 304) an electrical field magnitude distribution over time (E(t); Ec(t)) in said insulation layer (203) by measuring (302) physical parameters (V(t), T(t) I(t)) of the electrical component (200) in operation;
detecting (305), in proximity to the electrical component (200), electromagnetic pulses (Pᵢ) and providing a trend of a detected pulse number (P(t));
processing (307) the trend of detected pulse number (P(t)) and the electrical field magnitude distribution over time (E(t); Ec(t)) to obtain a correspondence trend (Pj(E); ANᵢ(ELₓ)) representing a relation of said detected pulse number with electrical field magnitudes;
analysing (308) the correspondence trend (Pj(E); ANᵢ(ELₓ)) and selectively recognizing partial discharges (PD) and noise (NS) depending on an increasing of the detected pulse number as the electrical field magnitudes increase.

2. The recognition method (300) of claim 1, wherein analysing (308) the correspondence trend (Pj(E); ANᵢ(ELₓ)) comprises:
recognizing partial discharges (PD) when the detected pulse number increases as the electrical field magnitudes increase in accordance with threshold-based criterion;
not recognizing partial discharges (PD) when the detected pulse number does not increase as the electrical field magnitudes increase, in accordance with said threshold-based criterion.

3. The recognition method (300) of claim 2, wherein said threshold-based criterion comprises:
defining a partial discharge inception electric filed threshold (ETH_{inc}) dividing the correspondence trend (Pj(E); ANᵢ(ELₓ)) into a first sub-trend below the inception electric filed threshold and a second sub-trend above inception electric filed threshold;
defining a comparison threshold;
computing a ratio between the number of pulses associated with the second sub-trend and the number of pulses associated with the first sub-trend;
compare said ratio with the comparison threshold and selectively recognizing partial discharges (PD) and noise (NS) depending on the result of the comparison.

4. The recognition method (300) of any of previous claims, wherein said electrical field magnitude distribution over time (E(t)) indicates trends over time of electrical field magnitude values assumed in a plurality of points of interest (i₁-i_{L}) distributed in the insulation layer (203).

5. The recognition method (300) of any of previous claims, further including
defining (301) an observation time (OT) during which performing said measuring (302) of physical parameters (V(t), T(t) I(t));
wherein said processing (307) comprises:
dividing (401) said observation time (OT) into a plurality of sub-periods (SP_{y});
calculating (404) average electric field magnitude values (E_{Ax}), each associated to corresponding sub-periods (SP_{y});
associating (405) each calculated average electric field magnitude value (E_{Ax}) to an electric field magnitude level (ELₓ) among a plurality of electric field magnitude levels;
calculating (406) for any of said sub-periods (SP_{y}) a corresponding pulse number (N_{y}) of said electromagnetic pulses ((Pᵢ)) detected in the corresponding sub-period, thus obtaining a plurality of pulse numbers (Ny);
grouping (407) the plurality of pulse numbers (Ny) according to the plurality of electric field magnitude levels (ELₓ) associated to the same sub-periods (SP_{y}) so as to obtain a plurality of groups of pulse numbers; computing an average number of pulses (ANᵢ) for each group of pulse numbers; each average number of pulses (ANᵢ) being associated to one of the plurality of electric field magnitude levels (ELₓ);
constructing said correspondence trend (ANᵢ(ELₓ)) by expressing each average number of pulses (ANᵢ) in function of a corresponding electric field magnitude level (ELₓ).

6. The recognition method (300) of any of previous claims, wherein:
measuring (302) the physical parameters (V(t), T(t), I(t)) is performed synchronously with the detection (305) of the electromagnetic pulses (Pᵢ).

7. The recognition method (300) of any of previous claims, further comprising:
computing (304) a corrected electric field distribution over time (E_{c}(t)) by multiplying said electrical field magnitude distribution over time (E(t)) by an amplification/reduction coefficient (c) to express an electric field that would be reached in the defect (206) in said insulation layer (203).

8. The recognition method (300) of any of previous claims, further comprising:
grouping (306) the electromagnetic pulses (Pᵢ) into a first group of pulses (Pj) and at least a second group of pulses (Px) according to a differentiation criterion based on at least one of the following pulse features: pulse shape; pulse magnitude, pulse repetition frequency, pulse rise time, pulse fall time, pulse duration, pulse peak.

9. The recognition method (300) of claim 8, further comprising
providing a first time trend of pulse number (Pj(t)) associated with the first group of pulses (Pj);
providing at least a second time trend of pulse number (Px(t)) associated with said at least a second group of pulses (Px);
wherein:
processing (307) the trend of detected pulse number (P(t)) and the electrical field magnitude distribution over time (E(t); Ec(t)) to obtain the correspondence trend (Pj(E); ANᵢ(ELₓ)) includes: processing (307) said first time trend of pulse number (Pj(t)) and processing said at least a second time trend of pulse number (Px(t)).

10. The recognition method (300) of claim 8 or 9, wherein said differentiation criterion is based on the pulse shape.

11. The recognition method (300) of any of previous claims, wherein measuring (302) physical parameters of the electrical component (200) in operation comprises:
measuring an electric voltage time trend (V(t)) in the electrical component (200);
measuring an electric current time (I(t)) in the electrical component (200);
measuring a temperature time trend (T(t)) along the electrical component (200).

12. The recognition method (300) of any of previous claims, wherein said electrical component is one of the following components: DC cable, HVDC cable, MVDC cable, DC cable joint, DC accessory.

13. The recognition method (300) of claim 12, wherein said electrical component is a DC cable (200) having a dielectric layer (203).

14. Partial discharge recognition system (100) comprising:
- an electric field estimation apparatus (1) configured to:
measure (302) physical parameters (V(t), T(t) I(t)) of an insulation layer (203) of DC electrical component (200) in operation; said insulation layer (203) can include a defect (206) causing partial discharges;
estimating (303; 304) an electrical field magnitude distribution over time (E(t); Ec(t)) in said insulation layer (203) from said measured physical parameters (V(t), T(t) I(t));
- a partial discharge sensor (2) configured to detect (305), in proximity to the electrical component (200), electromagnetic pulses (Pi) and providing a trend of a detected pulse number (P(t));
- a partial discharge recognition apparatus (3) configured to:
process (307) the trend of detected pulse number (P(t)) and the electrical field magnitude distribution over time (E(t); Ec(t)) to obtain a correspondence trend (Pj(E); ANᵢ(ELₓ)) representing a relation of said detected pulse number with electrical field magnitudes;
analyse (308) the correspondence trend (Pj(E); ANᵢ(ELₓ)) and selectively recognizing partial discharges (PD) and noise (NS) depending on an increasing of the detected pulse number as the electrical field magnitudes increase.

## Patentansprüche

1. Verfahren zur Erkennung von Teilentladungen (300), umfassend:
Bereitstellen einer elektrischen Komponente (200) mit einer Isolierschicht (203), die einen Defekt (206) aufweisen kann, der Teilentladungen verursacht;
Inbetriebnahme der elektrischen Komponente (200) durch Anlegen einer elektrischen Gleichspannung (V(t)) und Erzeugen eines entsprechenden elektrischen Stroms (I(t)), der in der elektrischen Komponente (200) fließt;
Schätzen (303; 304) einer zeitlichen Verteilung der elektrischen Feldstärke (E(t); Ec(t)) in der Isolationsschicht (203) durch Messen (302) physikalischer Parameter (V(t), T(t) I(t)) der elektrischen Komponente (200) im Betrieb;
Erfassen (305) elektromagnetischer Impulse (Pi) in der Nähe der elektrischen Komponente (200) und Bereitstellen eines Trends einer erfassten Impulszahl (P(t));
Verarbeiten (307) des Trends der erfassten Impulszahl (P(t)) und der zeitlichen Verteilung der elektrischen Feldstärke (E(t); Ec(t)), um einen Korrespondenz-Trend (Pj(E);
ANᵢ(ELₓ)) zu erhalten, der eine Beziehung zwischen der erfassten Impulszahl und den elektrischen Feldstärken darstellt;
Analysieren (308) des Korrespondenz-Trends (Pj(E); ANᵢ(ELₓ)) und selektives Erkennen von Teilentladungen (PD) und Rauschen (NS) in Abhängigkeit von einem Anstieg der erfassten Impulszahl bei zunehmender elektrischer Feldstärke.

2. Erkennungsverfahren (300) nach Anspruch 1, wobei das Analysieren (308) des Korrespondenzverlaufs (Pj(E)); ANᵢELₓ)) umfasst:
Erkennen von Teilentladungen (PD), wenn die erfasste Impulszahl mit zunehmender elektrischer Feldstärke gemäß einem schwellenwertbasierten Kriterium zunimmt;
Nicht-Erkennen von Teilentladungen (PD), wenn die erfasste Impulszahl mit zunehmender elektrischer Feldstärke gemäß dem genannten Kriterium basierenden Schwellenwert nicht zunimmt.

3. Das Erkennungsverfahren (300) nach Anspruch 2, wobei das schwellenwertbasierte Kriterium umfasst:
Definieren eines Schwellenwerts für das elektrische Feld zu Beginn einer Teilentladung (ETH_{inc}), der den Korrespondenzverlauf (Pj(E); ANᵢ(ELₓ)) in einen ersten Teilverlauf unterhalb des Schwellenwerts für das elektrische Feld zu Beginn und einen zweiten Teilverlauf oberhalb des Schwellenwerts für das elektrische Feld zu Beginn unterteilt; Definieren eines Vergleichsschwellenwerts;
Berechnen eines Verhältnisses zwischen der Anzahl von Impulsen, die mit dem zweiten Untertrend verbunden sind, und der Anzahl von Impulsen, die mit dem ersten Untertrend verbunden sind;
Vergleichen des Verhältnisses mit dem Vergleichsschwellenwert und selektives Erkennen von Teilentladungen (PD) und Rauschen (NS) in Abhängigkeit vom Ergebnis des Vergleichs.

4. Das Erkennungsverfahren (300) nach einem der vorherigen Ansprüche, wobei die zeitliche Verteilung der elektrischen Feldstärke (E(t)) Trends über die Zeit von Werten der elektrischen Feldstärke angibt, die an einer Vielzahl von interessierenden Punkten (i₁-i_{L}) angenommen werden, die in der Isolierschicht (203) verteilt sind.

5. Das Erkennungsverfahren (300) nach einem der vorherigen Ansprüche, das ferner das Definieren (301) einer Beobachtungszeit (OT) umfasst, während der die Messung (302) der physikalischen Parameter (V(t), T(t), I(t)) durchgeführt wird;
wobei die Verarbeitung (307) umfasst:
Aufteilen (401) der Beobachtungszeit (OT) in mehrere Teilperioden (SP_{y});
Berechnen (404) durchschnittlicher elektrischer Feldstärkewerte (E_{AX}), die jeweils entsprechenden Teilperioden (SP_{y}) zugeordnet sind;
Zuordnen (405) jedes berechneten durchschnittlichen elektrischen Feldstärkewerts (E_{AX}) zu einem elektrischen Feldstärkepegel (ELₓ) aus einer Vielzahl von elektrischen Feldstärkepegeln;
Berechnen (406) für jede der Teilperioden (SP_{y}) einer entsprechenden Impulszahl (Ny) der elektromagnetischen Impulse ((Pi)), die in der entsprechenden Teilperiode erfasst wurden, wodurch eine Vielzahl von Impulszahlen (Ny) erhalten wird;
Gruppieren (407) der Vielzahl von Impulszahlen (Ny) gemäß der Vielzahl von elektrischen Feldstärkeniveaus (ELₓ) die denselben Teilperioden (SP_{y}) zugeordnet sind, um eine Vielzahl von Gruppen von Impulszahlen zu erhalten;
Berechnen einer durchschnittlichen Impulszahl (ANᵢ) für jede Gruppe von Impulszahlen; wobei jede durchschnittliche Impulszahl (ANᵢ) einem der mehreren elektrischen Feldstärkepegel (ELₓ) zugeordnet ist;
Erstellen des genannten Korrespondenzverlaufs (ANᵢ(ELₓ)), indem jede durchschnittliche Impulszahl (ANᵢ) in Abhängigkeit von einem entsprechenden elektrischen Feldstärkepegel (ELₓ) ausgedrückt wird.

6. Das Erkennungsverfahren (300) nach einem der vorhergehenden Ansprüche, wobei:
Das Messen (302) der physikalischen Parameter (V(t), T(t), I(t)) synchron mit dem Erfassen (305) der elektromagnetischen Impulse (Pᵢ) durchgeführt wird.

7. Das Erkennungsverfahren (300) nach einem der vorhergehenden Ansprüche, das ferner umfasst: Berechnen (304) einer korrigierten elektrischen Feldverteilung über die Zeit (Ec(t)) durch Multiplizieren der elektrischen Feldstärkenverteilung über die Zeit (E(t)) mit einem Verstärkungs-/Reduktionskoeffizienten (c), um ein elektrisches Feld auszudrücken, das in dem Defekt (206) in der Isolationsschicht (203) erreicht würde.

8. Das Erkennungsverfahren (300) nach einem der vorhergehenden Ansprüche, das ferner umfasst:
Gruppieren (306) der elektromagnetischen Impulse (Pi) in eine erste Gruppe von Impulsen (Pj) und mindestens eine zweite Gruppe von Impulsen (Px) gemäß einem Unterscheidungskriterium, das auf mindestens einem der folgenden Impulsmerkmale basiert: Impulsform, Impulsamplitude, Impulswiederholungsfrequenz, Impulsanstiegszeit, Impulsabfallzeit, Impulsdauer, Impulsspitze.

9. Das Erkennungsverfahren (300) nach Anspruch 8, das ferner umfasst: Bereitstellen eines ersten Zeitverlaufs der Impulszahl (Pj(t)), der mit der ersten Gruppe von Impulsen (Pj) verbunden ist;
Bereitstellen mindestens eines zweiten Zeitverlaufs der Impulszahl (Px(t)), der mit der mindestens einen zweiten Gruppe von Impulsen (Px) verbunden ist;
wobei:
Verarbeiten (307) des Verlaufs der erfassten Impulszahl (P(t)) und der zeitlichen Verteilung der elektrischen Feldstärke (E(t); Ec(t)), um den Korrespondenzverlauf (Pj(E); ANᵢ(ELₓ)) umfasst: Verarbeiten (307) des ersten Zeitverlaufs der Impulszahl (Pj (t)) und Verarbeiten des mindestens einen zweiten Zeitverlaufs der Impulszahl (Px(t)).

10. Das Erkennungsverfahren (300) nach Anspruch 8 oder 9, wobei das Unterscheidungskriterium auf der Impulsform basiert.

11. Das Erkennungsverfahren (300) nach einem der vorhergehenden Ansprüche, wobei das Messen (302) physikalischer Parameter der elektrischen Komponente (200) in Betrieb umfasst:
Messen eines elektrischen Spannungszeitverlaufs (V(t)) in der elektrischen Komponente (200);
Messen eines elektrischen Stromzeitverlaufs (I(t)) in der elektrischen Komponente (200); Messen eines Temperaturzeitverlaufs (T(t)) entlang der elektrischen Komponente (200).

12. Das Erkennungsverfahren (300) nach einem der vorhergehenden Ansprüche, wobei die elektrische Komponente eine der folgenden Komponenten ist: Gleichstromkabel, HVDC-Kabel, MVDC-Kabel, Gleichstromkabelverbindung, Gleichstromzubehör.

13. Das Erkennungsverfahren (300) nach Anspruch 12, wobei die elektrische Komponente ein Gleichstromkabel (200) mit einer dielektrischen Schicht (203) ist.

14. Teilentladungserkennungssystem (100), umfassend:
- eine elektrische Feldschätzvorrichtung (1), die konfiguriert ist, um:
Messen (302) physikalischer Parameter (V(t), T(t), I(t)) einer Isolierschicht (203) einer elektrischen Gleichstromkomponente (200) im Betrieb; wobei die Isolierschicht (203) einen Defekt (206) aufweisen kann, der Teilentladungen verursacht;
Schätzen (303; 304) einer zeitlichen Verteilung der elektrischen Feldstärke (E(t); Ec(t)) in der Isolationsschicht (203) aus den gemessenen physikalischen Parametern (V(t), T(t) I(t));
- ein Teilentladungssensor (2), der so konfiguriert ist, dass er in der Nähe der elektrischen Komponente (200) elektromagnetische Impulse (Pi) erfasst (305) und einen Trend der erfassten Impulszahl (P(t)) liefert;
- eine Teilentladungserkennungsvorrichtung (3), die so konfiguriert ist, dass sie:
den Trend der erfassten Impulszahl (P(t)) und die zeitliche Verteilung der elektrischen Feldstärke (E(t); Ec(t)) verarbeitet (307), um einen Korrespondenz-Trend (Pj(E);
ANᵢ(ELₓ)), der eine Beziehung zwischen der erfassten Impulszahl und den elektrischen Feldstärken darstellt;
Analyse (308) des Korrespondenzverlaufs (Pj(E); ANᵢ(ELₓ)) und selektive Erkennung von Teilentladungen (PD) und Rauschen (NS) in Abhängigkeit von einem Anstieg der erfassten Impulszahl bei zunehmender elektrischer Feldstärke.

## Revendications

1. Procédé de reconnaissance (300) de décharge partielle comprenant :
la fourniture d'un composant électrique (200) comprenant une couche d'isolation (203) qui peut comporter un défaut (206) provoquant des décharges partielles ;
la mise en fonctionnement du composant électrique (200) en appliquant une tension électrique continue (V(t)) et en générant un courant électrique correspondant (I(t)) circulant dans le composant électrique (200) ;
l'estimation (303 ; 304) d'une répartition d'amplitude de champ électrique dans le temps (E(t) ; Ec(t)) dans ladite couche d'isolation (203) en mesurant (302) des paramètres physiques (V(t), T(t) I(t)) du composant électrique (200) en fonctionnement ;
la détection (305), à proximité du composant électrique (200), d'impulsions électromagnétiques (Pᵢ) et la fourniture d'une tendance d'un nombre d'impulsions détectées (P(t)) ;
le traitement (307) de la tendance du nombre d'impulsions détectées (P(t)) et de la répartition d'amplitude de champ électrique dans le temps (E(t) ; Ec(t)) pour obtenir une tendance de correspondance (Pj(E) ; ANᵢ(ELₓ )) représentant une relation dudit nombre d'impulsions détectées avec des amplitudes de champ électrique ;
l'analyse (308) de la tendance de correspondance (Pj(E) ; ANᵢ (ELₓ)) et la reconnaissance sélective de décharges partielles (PD) et de bruit (NS) en fonction d'une augmentation du nombre d'impulsions détectées à mesure que les amplitudes de champ électrique augmentent.

2. Procédé de reconnaissance (300) selon la revendication 1, dans lequel l'analyse (308) de la tendance de correspondance (Pj(E) ; ANᵢ(ELₓ)) comprend :
la reconnaissance de décharges partielles (PD) lorsque le nombre d'impulsions détectées augmente à mesure que les amplitudes de champ électrique augmentent conformément à un critère basé sur un seuil ;
la non-reconnaissance de décharges partielles (PD) lorsque le nombre d'impulsions détectées n'augmente pas à mesure que les amplitudes de champ électrique augmentent, conformément audit critère basé sur un seuil.

3. Procédé de reconnaissance (300) selon la revendication 2, dans lequel ledit critère basé sur un seuil comprend :
la définition d'un seuil de champ électrique de commencement de décharge partielle (ETH_{inc}) divisant la tendance de correspondance (Pj(E) ; ANᵢ (ELₓ)) en une première sous-tendance inférieure au seuil de champ électrique de commencement et une seconde sous-tendance supérieure au seuil de champ électrique de commencement ;
la définition d'un seuil de comparaison ;
le calcul d'un rapport entre le nombre d'impulsions associées à la seconde sous-tendance et le nombre d'impulsions associées à la première sous-tendance ;
la comparaison dudit rapport au seuil de comparaison et la reconnaissance sélective des décharges partielles (PD) et d'un bruit (NS) en fonction du résultat de la comparaison.

4. Procédé de reconnaissance (300) selon l'une quelconque des revendications précédentes, dans lequel ladite répartition d'amplitude de champ électrique dans le temps (E(t)) indique des tendances dans le temps de valeurs d'amplitude de champ électrique supposées dans une pluralité de points d'intérêt (i₁ -i_{L}) répartis dans la couche d'isolation (203).

5. Procédé de reconnaissance (300) selon l'une quelconque des revendications précédentes, comportant en outre
la définition (301) d'un temps d'observation (OT) au cours duquel on réalise ladite mesure (302) de paramètres physiques (V(t), T(t) I(t)) ;
dans lequel ledit traitement (307) comprend :
la division (401) dudit temps d'observation (OT) en une pluralité de sous-périodes (SP_{y}) ;
le calcul (404) de valeurs moyennes d'amplitude de champ électrique (E_{Ax}), chacune associée à des sous-périodes (SP_{y}) correspondantes ;
l'association (405) de chaque valeur moyenne d'amplitude de champ électrique (E_{Ax}) calculée à un niveau d'amplitude de champ électrique (ELₓ) parmi une pluralité de niveaux d'amplitude de champ électrique ;
le calcul (406) pour l'une quelconque desdites sous-périodes (SP_{y}) d'un nombre d'impulsions (N_{y}) correspondant desdites impulsions électromagnétiques ((Pᵢ)) détectées dans la sous-période correspondante, obtenant ainsi une pluralité de nombres d'impulsions (Ny) ;
le regroupement (407) de la pluralité de nombres d'impulsions (Ny) selon la pluralité de niveaux d'amplitude de champ électrique (ELₓ) associés aux mêmes sous-périodes (SP_{y}) de manière à obtenir une pluralité de groupes de nombres d'impulsions ; le calcul d'un nombre moyen d'impulsions (ANᵢ) pour chaque groupe de nombres d'impulsions ; chaque nombre moyen d'impulsions (ANᵢ) étant associé à l'un de la pluralité de niveaux d'amplitude de champ électrique (ELₓ) ;
la construction de ladite tendance de correspondance (ANᵢ(ELₓ)) en exprimant chaque nombre moyen d'impulsions (ANᵢ) en fonction d'un niveau d'amplitude de champ électrique (ELₓ) correspondant.

6. Procédé de reconnaissance (300) selon l'une quelconque des revendications précédentes, dans lequel :
la mesure (302) des paramètres physiques (V(t), T(t), I(t)) est effectuée de manière synchrone avec la détection (305) des impulsions électromagnétiques (Pᵢ).

7. Procédé de reconnaissance (300) selon l'une quelconque des revendications précédentes, comprenant en outre :
le calcul (304) d'une répartition de champ électrique corrigée dans le temps (E_{c}(t)) en multipliant ladite répartition d'amplitude de champ électrique dans le temps (E(t)) par un coefficient d'amplification/de réduction (c) pour exprimer un champ électrique qui serait atteint dans le défaut (206) dans ladite couche d'isolation (203).

8. Procédé de reconnaissance (300) selon l'une quelconque des revendications précédentes, comprenant en outre :
le regroupement (306) des impulsions électromagnétiques (Pᵢ) en un premier groupe d'impulsions (Pj) et au moins un second groupe d'impulsions (Px) selon un critère de différenciation basé sur au moins l'une des caractéristiques d'impulsion suivantes : forme d'impulsion ; amplitude d'impulsion, fréquence de répétition d'impulsion, temps de montée d'impulsion, temps de chute d'impulsion, durée d'impulsion, pic d'impulsion.

9. Procédé de reconnaissance (300) selon la revendication 8, comprenant en outre
la fourniture d'une première tendance temporelle de nombre d'impulsions (Pj(t)) associées au premier groupe d'impulsions (Pj) ;
la fourniture d'au moins une seconde tendance temporelle de nombre d'impulsions (Px(t)) associées audit au moins un second groupe d'impulsions (Px) ;
dans lequel :
le traitement (307) de la tendance du nombre d'impulsions détectées (P(t)) et de la répartition d'amplitude de champ électrique dans le temps (E(t) ; Ec(t)) pour obtenir la tendance de correspondance (Pj(E) ; ANᵢ(ELₓ)) comporte : le traitement (307) de ladite première tendance temporelle de nombre d'impulsions (Pj(t)) et le traitement de ladite au moins une seconde tendance temporelle de nombre d'impulsions (Px(t)).

10. Procédé de reconnaissance (300) selon la revendication 8 ou 9, dans lequel ledit critère de différenciation est basé sur la forme d'impulsion.

11. Procédé de reconnaissance (300) selon l'une quelconque des revendications précédentes, dans lequel la mesure (302) de paramètres physiques du composant électrique (200) en fonctionnement comprend :
la mesure d'une tendance temporelle de tension électrique (V(t)) dans le composant électrique (200) ;
la mesure d'un temps de courant électrique (I(t)) dans le composant électrique (200) ;
la mesure d'une tendance temporelle de température (T(t)) le long du composant électrique (200).

12. Procédé de reconnaissance (300) selon l'une quelconque des revendications précédentes, dans lequel ledit composant électrique est l'un des composants suivants : Câble CC, câble HVDC, câble MVDC, joint de câble CC, accessoire CC.

13. Procédé de reconnaissance (300) selon la revendication 12, dans lequel ledit composant électrique est un câble CC (200) présentant une couche diélectrique (203).

14. Système de reconnaissance de décharge partielle (100) comprenant :
- un appareil d'estimation de champ électrique (1) configuré pour :
mesurer (302) des paramètres physiques (V(t), T(t) I(t)) d'une couche d'isolation (203) de composant électrique CC (200) en fonctionnement ; ladite couche d'isolation (203) peut comporter un défaut (206) provoquant des décharges partielles ;
l'estimation (303 ; 304) d'une répartition d'amplitude de champ électrique dans le temps (E(t) ; Ec(t)) dans ladite couche d'isolation (203) à partir desdits paramètres physiques (V(t), T(t) I(t)) mesurés ;
- un capteur de décharge partielle (2) configuré pour détecter (305), à proximité du composant électrique (200), des impulsions électromagnétiques (Pi) et fournir une tendance d'un nombre d'impulsions détectées (P(t)) ;
- un appareil de reconnaissance de décharge partielle (3) configuré pour :
traiter (307) la tendance de nombre d'impulsions détectées (P(t)) et la répartition d'amplitude de champ électrique dans le temps (E(t) ; Ec(t)) pour obtenir une tendance de correspondance (Pj(E) ; ANᵢ(ELₓ)) représentant une relation dudit nombre d'impulsions détectées avec des amplitudes de champ électrique ;
analyser (308) la tendance de correspondance (Pj(E) ; ANᵢ(ELₓ)) et reconnaître sélectivement des décharges partielles (PD) et un bruit (NS) en fonction d'une augmentation du nombre d'impulsions détectées à mesure que les amplitudes de champ électrique augmentent.
